# EUROPEAN PATENT APPLICATION

(11) **EP 2 172 524 A1**
(43) Date of publication of application: **07.04.2010**
(21) Application number: 08791130.1
(22) Date of filing: 14.07.2008
(51) Int. Cl.: C08L 101/00, C08K 13/02, C09D 7/12, C09D 201/00, G01N 21/84, H01L 23/14, H05K 3/00, H05K 3/28

(54) **RESIN COMPOSITION AND ITS USE**

(30) Priority: 18.07.2007 JP 2007186491
(71) Applicant: Showa Denko K.K., Tokyo 105-8518 (JP)
(72) Inventor: ONISHI, Mina, Tokyo 105-8518 (JP); INOUE, Hirofumi, Tokyo 105-8518 (JP)
(74) Representative: Strehl Schübel-Hopf & Partner
(86) International application number: PCT/JP2008/062705
(87) International publication number: WO 2009/011337

(57) **Abstract**

Resin compositions have excellent visibility such that they are displayed in an accurate black-and-white image via a CCD camera under the illumination of green or red light irrespective of the light intensity or conditions of the CCD camera.

The resin composition includes a color pigment (A) and a curable resin (B) and gives a cured film satisfying the following requirements (I), (II), (III), (IV) and (V): (I) the maximum transmittance of light having wavelengths of 500 nm to 550 nm is not less than 90%; (II) the minimum transmittance of light having wavelengths of 600 nm to 650 nm is less than 80%; (III) the maximum reflectance of light having wavelengths of 500 nm to 550 nm is less than 12%; (IV) the minimum reflectance of light having wavelengths of 600 nm to 650 nm is less than 7%; (V) the 60° gloss value measured with white light is not less than 80.

## Description

### FIELD OF THE INVENTION

The present invention relates to resin composition suitable as surface protective films for electronic circuit boards, and uses of the compositions.

### BACKGROUND OF THE INVENTION

Coverlay films and overcoating agents are known as surface protective films for flexible circuit boards. The coverlay films are punched to a pattern shape with a mold and are applied to the circuit boards with an adhesive to protect the circuit surface. The overcoating agents include flexible, UV-curable or heat-curable overcoating agents.

In the inspection of electronic circuit boards coated with these surface protective films, workers inspect individual boards for foreign matters, bubbles and aggregated pigments or fillers in the surface protective films, and defective circuits visually or through a microscope. The color tone of the surface protective films is generally green that is agreeable to the eyes. In recent years, the inspection of electronic circuit boards coated with the surface protective films has become highly automated. For example, an electronic circuit board coated with the surface protective film is inspected with respect to a black-and-white image converted through a CCD camera from a reflected image of the electronic circuit board under the illumination of green light having wavelengths of 500 nm to 550 nm or red light having wavelengths of 600 nm to 650 nm. Alternatively, an electronic circuit board coated with the surface protective film is inspected with respect to a black-and-white image converted through a CCD camera from a transmitted image of the electronic circuit board under the illumination of red light. These inspection methods are performed singly or in combination with each other to inspect for foreign matters, bubbles and aggregated pigments or fillers in the surface protective films, and defective circuits. By these methods, the inspection time is shortened and the workers are downsized.

Patent Document 1 discloses a method in which polarizing filters are disposed on and under an insulating film and the insulating film is inspected by receiving light that has passed through the polarizing filters with a CCD camera and image-processing the difference in brightness.

In this method, however, a real image cannot be obtained correctly depending on the light intensity or the angle or sensitivity of the CCD camera.

There is therefore a need for technique that can produce a correct image irrespective of some variations in inspection conditions.
Patent Document 1: JP-A-2005-315767

### SUMMARY OF THE INVENTION

The present invention is aimed at solving the problems in the art as described above. It is therefore an object of the invention to provide resin compositions that can give cured films with excellent visibility such that a real image is obtained under the illumination of green or red light irrespective of the light intensity or conditions of an image-processing system including a camera. It is another object of the invention to provide cured films of the compositions and methods for inspecting electronic circuit boards coated with the cured films.

The present inventors studied diligently to solve the problems in the art as described above. They have then found that resin compositions having excellent visibility in automated inspection of electronic circuit boards are obtained by improving characteristics of resin compositions that form surface protective films for electronic circuit boards.

The present invention is concerned with the following.

(1) A resin composition which comprises a color pigment (A) and a curable resin (B) and wherein a film (dry thickness: 10 µm ± 1 µm) comprising a cured product of the resin composition satisfies the following requirements (I), (II), (III), (IV) and (V):
   (I) the maximum transmittance of light having wavelengths of 500 nm to 550 nm is not less than 90%;
   (II) the minimum transmittance of light having wavelengths of 600 nm to 650 nm is less than 80%;
   (III) the maximum reflectance of light having wavelengths of 500 nm to 550 nm is less than 12%;
   (IV) the minimum reflectance of light having wavelengths of 600 nm to 650 nm is less than 7%;
   (V) the 60° gloss value measured with white light is not less than 80.

(2) The resin composition described in (1) above, wherein the composition contains the color pigment (A) at 0.2 to 5 parts by mass based on 100 parts by mass of the total of the color pigment (A) and the curable resin (B).

(3) The resin composition described in (1) or (2) above, wherein the average diameter of dispersed particles of the color pigment (A) is not more than 1 µm.

(4) The resin composition described in any one of (1) to (3) above, wherein the color pigment (A) is at least one pigment and shows a green color.

(5) The resin composition described in any one of (1) to (4) above, wherein the curable resin (B) is a heat-curable resin or a UV-curable resin.

(6) The resin composition described in any one of (1) to (5) above, wherein the composition further comprises an inorganic filler or an organic filler and the average diameter of dispersed particles of the inorganic filler or the organic filler is not more than 10 µm.

(7) A cured film obtained by curing the resin composition described in any one of (1) to (6) above.

(8) The cured film described in (7) above, wherein the cured film has a matrix/domain structure and the average diameter of the dispersed domains in the matrix/domain structure is not more than 10 µm.

(9) A cured resin film satisfying the following requirements (I), (II), (III), (IV) and (V):
   (I) the maximum transmittance of light having wavelengths of 500 nm to 550 nm is not less than 90%;
   (II) the minimum transmittance of light having wavelengths of 600 nm to 650 nm is less than 80%;
   (III) the maximum reflectance of light having wavelengths of 500 nm to 550 nm is less than 12%;
   (IV) the minimum reflectance of light having wavelengths of 600 nm to 650 nm is less than 7%;
   (V) the 60° gloss value measured with white light is not less than 80.

(10) An overcoat for electronic circuit boards comprising the cured film described in any one of (7) to (9) above.

(11) An electronic circuit board which has a surface partially or entirely coated with the cured film described in any one of (7) to (9) above.

(12) An electronic device comprising the electronic circuit board described in (11) above.

(13) A method for inspecting electronic circuit boards, which comprises inspecting an electronic circuit board having a surface partially or entirely coated with the cured film described in any one of (7) to (9) above, via a reflected image and/or a transmitted image of the board projected through a camera under the illumination of light.

(14) The method for inspecting electronic circuit boards described in (13) above, wherein the illumination of light is illumination of green light and/or illumination of red light.

(15) The method for inspecting electronic circuit boards described in (13) or (14) above, wherein the camera is a CCD camera.

### ADVANTAGEOUS EFFECTS OF THE INVENTION

The resin compositions of the invention have excellent visibility and are suitable as surface protective films for electronic circuit boards. The surface protective films allow for accurate automated inspection of electronic circuit boards coated therewith, and foreign matters, bubbles and aggregated pigments or fillers in the surface protective films and defective circuits can be detected accurately irrespective of the light intensity or conditions of image-processing systems such as the angle or sensitivity of CCD camera.

### BRIEF DESCRIPTION OF THE DRAWINGS

Fig. 1 shows a pattern of transmittance in Example 3.
Fig. 2 shows a pattern of reflectance in Example 3.

### PREFERRED EMBODIMENTS FOR CARRYING OUT THE INVENTION

The resin compositions of the present invention will be described in detail hereinbelow.

The resin compositions according to the present invention are useful as surface protective films for electronic circuit boards.

If surface protective films from resin compositions have a transmittance of green-wavelength light of less than 90%, the green color is faded and therefore the amount of light from a lamp should be increased.

However, increasing the amount of light results in a large contrast difference between wires of an electronic circuit board that are exposed from the surface protective film, and the electronic circuit board coated with the surface protective film. Consequently, a real image cannot be projected accurately by a CCD camera.

To permit an accurate inspection of wires on an electronic circuit board coated with a surface protective film without increasing the amount of light, it is preferable that the maximum transmittance of light having green-wavelengths of 500 nm to 550 nm is not less than 90%. To inspect for foreign matters or the like and to achieve higher detection sensitivity for defective wires on an electronic circuit board, it is more preferable that the maximum transmittance of light having green-wavelengths of 500 nm to 550 nm is not less than 95%.

The maximum transmittance increases with decreasing amount of the color pigment (A) or an inorganic or organic filler having high opacifying properties. However, excessively small amounts of the pigment or the filler may cause problems such as increased reflectance.

The amount of the color pigment (A) is preferably controlled within the range of 0.2 to 5 parts by mass, more preferably 0.3 to 2 parts by mass, and most preferably 0.5 to 1.5 parts by mass based on 100 parts by mass of the total of the color pigment (A) and the curable resin (B).

The amount of the inorganic filler and/or the organic filler is variable because the opacifying properties vary depending on the average dispersed particle diameter of the filler and because in the case of the organic fillers, the composition becomes transparent or semi-transparent depending on the refractive index of the resin. In an embodiment, the maximum transmittance may be controlled appropriately as long as the total amount of the inorganic filler and/or the organic filler and the color pigment (A) is in the range of 10 to 40 parts by mass based on 100 parts by mass of the total of the color pigment (A) and the curable resin (B). When the resin compositions and the cured films therefrom have a matrix/domain structure, the resin components forming the domains are regarded as organic fillers.

Light having 600-650 nm wavelengths is unfavorable and therefore the transmittance of such light is preferably low. The minimum transmittance of light having wavelengths of 600 nm to 650 nm is preferably less than 80%, and more preferably less than 75%. When the minimum transmittance of light having 600-650 nm wavelengths is less than 75%, the detection sensitivity for foreign matters or the like may be further increased.

The minimum transmittance of light having 600-650 nm wavelengths decreases with increasing amount of the color pigment (A). However, excessively large amounts of the pigment may cause problems such as decreased maximum transmittance of 500-550 nm wavelength light. To control the minimum and maximum transmittances appropriately, it is preferable that the amount of the color pigment (A) is in the above-mentioned range and the average dispersed particle diameter of the color pigment (A) is not more than 1 µm. The average dispersed particle diameter of the color pigment (A) being not more than 1 µm is also preferable from the viewpoint of increased coloring power.

If the minimum transmittance of 600-650 nm wavelength light is 80% or above, not only the composition will show a light green color but also minor print unevenness that does not affect characteristics of the electronic circuit boards may be detected in inspection under the illumination of red light.

The transmittance is measured by preparing a sample by printing and curing the resin composition in a dry thickness of 10 µm ± 1 µm on a 20 to 25 µm thick polyethylene film and analyzing the sample with spectrophotometer UV-3100 PC (manufactured by Shimadzu Corporation) equipped with integrating sphere attachment LISR-3100 (150 mm diameter). In the measurement, the background adjustment is made with the transmittance of the polyethylene film at 100%.

The maximum reflectance is preferably less than 12%. If the maximum reflectance is 12% or more, a reflected image of an electronic circuit board coated with the surface protective film tends to show the thickness of wires inaccurately.
Further, when the amount of light from a lamp is increased, edge faces of the printed surface protective film shine to show gloss lines perpendicular to the wires of the electronic circuit board and such lines may be misrecognized as wires.

Accordingly, when inspection is made under the illumination of green light for example, a reflectance required for the composition to develop the color is suitably in the wavelength region of from 500 nm to 550 nm. If the minimum reflectance of light having wavelengths of 600 nm to 650 nm is less than 7%, the maximum reflectance of 500-550 nm light is preferably less than 12%. In a more preferred embodiment, the maximum reflectance of 500-550 nm light is less than 10% and the minimum reflectance of 600-650 nm light is less than 5%, in which case good visibility is ensured irrespective of the amount of light or the lamp angle.

If the minimum reflectance of 600-650 nm wavelength light is 7% or more, not only the composition will show a light green color but also edge faces of the printed surface protective film tend to shine when the amount of light from a lamp is increased. Inspection under the illumination of red light mainly addresses foreign matters. If the minimum reflectance of 600-650 nm light is 7% or more, the composition becomes whitish and the inspection for foreign matters tends to be difficult.

The minimum reflectance of 600-650 nm light being less than 7%, preferably less than 5%, tends to permit clear recognition of foreign matters irrespective of light intensity.

The reflectance may be measured using the same apparatus as that for measuring the transmittance described above. The reference is a barium sulfate plate that is white according to the Munsell color system. The background adjustment is made with the reflectance of the white plate at 100%.

Matting is one method for reducing the gloss on edge faces of the printed surface protective film. The term matting means to reduce the gloss value. With a reduced gloss value, the surface protective film does not show gloss lines perpendicular to the wires of the electronic circuit board and the false recognition of wires is unlikely. However, matting also reduces clearness on the surface protective film and causes birefringence in the surface protective film. Consequently, the wires covered underneath the matted surface protective film are often shown differently from the real image. Further, inorganic fillers or organic fillers added for matte effects are observed in a transmitted image projected under the illumination of red light, and such fillers may be misrecognized as foreign matters.

Thus, matting is not suitable in obtaining good visibility of the surface protective films.

The gloss value of cured films from the resin compositions according to the invention is measured with a digital variable gloss meter (Suga Test Instruments Co., Ltd.) setting the incident light angle and the light receiver angle both at 60°.

When the gloss value is 80 or above, a reflected image under the illumination of green and red lights and a transmitted image under the illumination of red light tend to be observed clearly with excellent visibility.

The resin compositions of the invention contain at least the color pigment (A) and the curable resin (B).

The amount of the color pigment (A) should be sufficient to produce a color. The amount is preferably in the range of 0.2 to 5 parts by mass, more preferably 0.3 to 2 parts by mass, and still more preferably 0.5 to 1.5 parts by mass based on 100 parts by mass of the color pigment (A) and the curable resin (B) combined.

If the amount is less than 0.2%, the reflectance is increased such that the reflectance at 500-550 nm wavelength exceeds 12% and the visibility is deteriorated due to the reasons as described hereinabove.

The average dispersed particle diameter of the color pigment (A) is preferably not more than 1 µm, more preferably in the range of 0.1 to 0.5 µm, and still more preferably 0.1 to 0.4 µm.

The average dispersed particle diameter of the color pigment (A) refers to a particle size in a particle size distribution which corresponds to 50% the volume of the particles accumulated from smaller particles. The average dispersed particle diameter may be measured by suspending the resin composition in diethylene glycol ethyl ether acetate to a proper concentration and analyzing the suspension with laser diffraction light-scattering particle size distribution analyzer MICROTRACK SPA (manufactured by NIKKISO CO., LTD.).

The color pigment (A) develops a color more efficiently as the average dispersed particle diameter is smaller. When the average dispersed particle diameter is not more than 1 µm, high coloring power and good visibility are achieved. If the average dispersed particle diameter is more than 1 µm, the color pigment shows deteriorated coloring power and may be detected as foreign matters.

In a preferred embodiment, the color pigment (A) is dry milled or wet milled beforehand to pulverize the primary particles into finer diameters. When the average dispersed particle diameter of the color pigment (A) is controlled by dry milling, apparatuses such as attritors, oscillating mills, ball mills and jet mills may be used. When the average dispersed particle diameter of the color pigment (A) is controlled by wet milling, solvents, pigment dispersions or resin solutions having good wetting properties with the color pigment (A) may be added, and apparatuses such as paint shakers, bead mills and three-roll mills may be used.

A small average dispersed particle diameter of the color pigment (A) may be achieved by blending the pigment by means of a dissolver or a high-speed high-shear mixer, a butterfly mixer for high-viscosity fluids, a planetary mixer or a three-roll mill. In a preferred embodiment, the color pigment (A) is kneaded with a small amount of the curable resin (B) in a three-roll mill to give a color pigment masterbatch, and in this manner the color pigment (A) may be controlled more efficiently to an average dispersed particle diameter of not more than 1 µm. However, the production processes are not particularly limited as long as the color pigment (A) is controlled to an average dispersed particle diameter of not more than 1 µm.

The color pigments (A) may have any colors such as green, blue, red and yellow.

As the color pigments (A), inorganic pigments or organic pigments may be used.

The inorganic pigments include oxides, sulfides and sulfates of zinc, lead, titanium, cadmium, iron or cobalt.

The organic pigments include nitroso pigments, nitro pigments, azo pigments, dyeing lake pigments, phthalocyanine pigments, and condensed polycyclic pigments such as threne, quinacridone, isoindolinone and dioxadine. Green pigments used as ecology colors are more preferred. Examples of the green pigments include chromium oxide green pigments, cobalt chromium green pigments, and chlorinated or brominated copper phthalocyanine pigments.

One or more kinds of the color pigments (A) may be used. Blue pigments and yellow pigments may be mixed to produce a green color. Examples of the blue pigments include α-crystalline or β-crystalline phthalocyanine pigments in which the central metal is Cu, Ni, Co or Fe, and alkali blue pigments. Examples of the yellow pigments include benzimidazolone pigments, anthraquinone pigments and isoindolinone pigments. Halogen-free green pigment compositions as described in JP-A-2002-194242 may be used.

The curable resins (B) in the resin compositions of the invention may be natural resins, modified resins or synthetic resins.

Typical examples of the natural resins are rosins. Examples of the modified resins include rosin derivatives and rubber derivatives. Examples of the synthetic resins include epoxy resins, acrylic resins, maleic acid derivatives, polyester resins, melamine resins, polyurethane resins, polyimide resins and urea resins.

To prevent the color pigment from losing the color, the curable resins (B) are preferably curable by UV rays or heat, and heat-curable resins are more preferable.

Examples of the heat-curable resins include epoxy compounds, combinations of epoxy compounds with compounds having a carboxyl group, an alcoholic group or an amino group, and combinations of compounds having a carboxyl group, an alcoholic group or an amino group with compounds containing carbodiimide. Further, polyimide silica hybrids (e.g., HBAA-02 manufactured by Arakawa Chemical Industries, Ltd.) may be used in which an alkoxysilane compound is introduced to a specific site in a polyamic acid resin and the hybrid resin is heat-cured via a ring-closing reaction of the imide and the hydrolysis and condensation of the alkoxysilane.

Examples of the epoxy compounds include epoxy compounds having two or more epoxy groups in the molecule such as bisphenol A epoxy resins, hydrogenated bisphenol A epoxy resins, brominated bisphenol A epoxy resins, bisphenol F epoxy resins, novolak epoxy resins, phenol novolak epoxy resins, cresol novolak epoxy resins, alicyclic epoxy resins, N-glycidyl epoxy resins, bisphenol A novolak epoxy resins, chelated epoxy resins, glyoxal epoxy resins, amino group-containing epoxy resins, rubber-modified epoxy resins, dicyclopentadiene phenolic epoxy resins, silicone-modified epoxy resins and ε-caprolactone-modified epoxy resins. To obtain flame retardance, there may be used epoxy compounds in which atoms such as halogen, for example chlorine or bromine, or phosphorus are introduced in the structure of the compound. Further, bisphenol S epoxy resins, diglycidyl phthalate resins, heterocyclic epoxy resins, bixylenol epoxy resins, biphenol epoxy resins and tetraglycidyl xylenoyl ethane resins may be used. The epoxy resins used in the invention preferably have two or more epoxy groups in the molecule, but epoxy compounds having one epoxy group in the molecule may be used together therewith. Examples of the compounds having a carboxyl group include acrylate compounds as described above, but are not particularly limited thereto. The compounds having an alcoholic group or an amino group are not particularly limited.

In the invention, the curable resins (B) may be UV-curable resins.

Examples of the UV-curable resins include compounds having more than one ethylenically unsaturated group such as acrylic copolymers, epoxy (meth)acrylate resins and urethane (meth)acrylate resins. Exemplary monomers are compounds having carboxyl groups such as (meth)acrylic acid, 2-(meth)acryloyloxyethylsuccinic acid, 2-(meth)acryloyloxyethylphthalic acid and (meth)acryloyloxyethylhexahydrophthalic acid; vinyl compounds such as α-methylstyrene, (o-, m-, p-) hydroxystyrene and vinyl acetate; methyl (meth)acrylate, ethyl (meth)acrylate, trifluoroethyl acrylate, n-methyl(meth)acrylamide, n-methylpyrrolidone and N-(meth)acryloylmorpholine.

Part of the side chains of the acrylic copolymers of the above monomers may be reacted with epoxy groups of compounds that have an epoxy group and an ethylenically unsaturated group in the molecule, such as glycidyl (meth)acrylate, 3,4-epoxycyclohexylmethyl (meth)acrylate, 4-(2,3-epoxypropyl)butyl (meth)acrylate and allyl glycidyl ether. Further, part or all of the hydroxyl groups of the acrylic copolymers may be reacted with isocyanate groups of compounds that have an isocyanate group and an ethylenically unsaturated group in the molecule, such as 2-methacryloyloxyethyl isocyanate. Such acrylic copolymers having ethylenically unsaturated groups in side chains are also usable in the present invention. Also usable are urethane poly (meth) acrylates that are produced by addition reaction of compounds having two or more isocyanate groups per molecule with hydroxyl group-containing (meth)acrylate monomers.

Compounds having relatively low molecular weight are also usable, with examples including bisphenol A (meth)acrylates, EO-adducts of bisphenol A (meth)acrylates, 2-(meth)acryloyloxyethyl acid phosphate, 1,6-hexanediol (meth)acrylate, dimethylol tricyclodecane diacrylate, trimethylolpropane triacrylate and trimethylolpropane acrylic acid benzoate. These relatively low molecular weight compounds show higher compatibility in the mixing of the resin.

In the invention, it is preferable to use curing catalysts to cure the resin by UV rays or heat effectively. Exemplary curing catalysts include polyamines such as melamine, urea, urea derivatives and polybasic hydrazine; imidazole derivatives or triazine derivatives such as 2MZ, 2Pz, 2MZA-PW and 2PHZ manufactured by SHIKOKU CHEMICALS CORPORATION; polyvinylphenol bromides; organophosphines such as tris-2-cyanoethylphosphine; phosphonium salts such as hexadodecyl tributyl phosphonium chloride; cationic photopolymerization catalysts; and known curing accelerators.

In the invention, organic solvents may be used as diluents. It is preferable to use at least one organic solvent capable of dissolving the curable resins (B). If the dissolving power is weak, the curable resin will be precipitated in the drying process and may be recognized as foreign matters under the illumination of green or red light. The solvents preferably include at least one solvent system having a glycol skeleton. Examples of such solvents include diethylene glycol dimethyl ether, ethylene glycol diethyl ether, carbitol acetate, propylene glycol methyl ether acetate, dipropylene glycol methyl ether acetate, ethyl carbitol acetate and butyl carbitol acetate. Examples of the solvents further include γ-butyrolactone and N-methylpyrrolidone.

Suitable organic solvents vary depending on the methods of forming the cured films. When the resin composition is applied on a substrate by a screen printing method, high boiling solvents are preferable in view of printing suitability. In a more preferred embodiment, part or all of the solvents used in the resin composition have a boiling point of not less than 160°C.

The resin compositions of the invention may further contain inorganic fillers or organic fillers.

Examples of the inorganic fillers and the organic fillers used in the invention include powdered blends of inorganic carriers with silicone oils, powdered silicone resins or silicone rubbers, barium sulfate, talc, calcium carbonate, alumina, glass powder, fiber reinforcing agents such as boron nitride fibers, synthetic mica and silica. These fillers may be used singly, or two or more kinds may be used in combination.

The inorganic fillers or the organic fillers preferably have an average dispersed particle diameter of not more than 10 µm, and more preferably less than 1 µm. This average dispersed particle diameter reduces the probability that the inorganic fillers or the organic fillers are misrecognized as foreign matters in the inspection of the surface protective films and electronic circuit boards coated with the surface protective films through reflected images or transmitted images under the illumination of green or red light.

If the average dispersed particle diameter of the inorganic fillers or the organic fillers is in excess of 10 µm, matte effects are increased to reduce the gloss on edge faces of the printed surface protective film. Consequently, the surface protective film does not show gloss lines perpendicular to the wires of the electronic circuit board and the false recognition of wires is avoided. However, such a matte surface protective film loses clearness and has birefringence, and the wires covered underneath the surface protective film are observed differently from the real image.

The average dispersed particle diameter of the inorganic fillers or the organic fillers refers to a particle size in a particle size distribution which corresponds to 50% the volume of the particles accumulated from smaller particles. The average dispersed particle diameter may be measured using laser diffraction light-scattering particle size distribution analyzer MICROTRACK SPA (manufactured by NIKKISO CO., LTD.).

Examples of the organic fillers further include thermoplastic resins, heat-curable resins and rubbery polymers that are in the form of powder or liquid.

The thermoplastic resins include bipolymers and terpolymers of (meth)acrylic acid derivatives, styrene derivatives and butadiene derivatives. In the thermoplastic resins and the heat-curable resins as the organic fillers, at least one block segment is preferably compatible with the curable resin (B) and at least another one block segment is preferably incompatible with the curable resin (B). The block segment compatible with the curable resin (B) provides improved wetting properties with the curable resin (B) and the organic fillers, and prevents airspaces in the interface that could be recognized as bubbles in a transmitted image under the illumination of red light. The compatible block segment also provides toughness. The block segment that is incompatible with the curable resin (B) can be localized as domains with distinct hardness in the matrix/domain structure. These thermoplastic resins and the heat-curable resins may be sufficiently dispersed in a nano scale by conventional mixing techniques such as planetary mixers or three-roll mills. If the amount of the organic fillers is inappropriate or the resin composition is prepared by inappropriate mixing, the resultant domain structure often has an average dispersed particle diameter in excess of 10 µm. In such cases, matte effects reduce the gloss on edge faces of the printed surface protective film. Consequently, the surface protective film does not show gloss lines perpendicular to the wires of the electronic circuit board and the false recognition of wires is avoided. However, such a matte surface protective film has birefringence and the wires covered underneath the surface protective film are observed differently from the real image. Accordingly, when the cured film has a matrix/domain structure, the domains preferably have an average dispersed particle diameter of not more than 10 µm.

The particle diameters of the domains are determined by x200 observation of the particles through a polarizing filter attached to a conventional stereomicroscope. The average dispersed particle diameter of the domains herein is an average of the diameters of several tens to several hundreds of domains observed as described above.

In the mixing of the color pigment (A) and the curable resin (B) to produce the resin composition, they may be heated to an appropriate temperature, for example 15 to 90°C, to achieve good compatibility. When the inorganic fillers or the organic fillers, the solvents, the curing catalysts or various additives are mixed, they may be dispersed or kneaded in the composition by means of, for example, a disperser, a kneader, a three-roll mill or a bead mill, and optionally a resin solution may be added thereafter and stirred together as required.

Further, known additives may be used depending on use, with examples including antioxidants such as hindered amine antioxidants, UV absorbents such as benzophenone compounds, viscosity modifiers, antibacterial agents, fungicides, antistatic agents, plasticizers, lubricants, foaming agents, anti-foaming agents, leveling agents and compatibilizers.

The compositions of the invention can give cured films with good visibility as surface protective films for electronic circuit boards. To take advantage of the characteristics of the compositions according to the invention, the thickness of the cured films may be preferably in the range of 5 to 20 µm, and more preferably 7 to 15 µm.

The cured films according to the invention are preferably used as overcoats for electronic circuit boards.

The overcoats for electronic circuit boards are used to form insulating protective films on the surface of printed wiring boards or the like in order to ensure insulation between wires of the boards. The overcoats for electronic circuit boards to establish electric insulation may be formed by applying the composition on an object and curing it by light or heat. Alternatively, the composition may be formed into an overcoat separately from an object and may be laminated to the object.

The printed wiring boards are structures in which metal wires such as of copper are provided on a board substrate and the insulating protective film covers the board surface. The board substrates include epoxy resin/glass (nonwoven) fabric composite substrates, epoxy resin/paper composite substrates, phenolic resin/paper composite substrates, BT resin/glass (nonwoven) fabric composite substrates, polyethylene terephthalate resin (PET) substrates, polyimide resin substrates, liquid crystal polymer substrates and glass substrates.

The metal wires are provided on one or both surfaces of the board substrate. When they are formed on both surfaces, the wires on the two surfaces may be partially connected via through-holes or the like.

The wires may be formed directly on the board substrate or may be bonded through an adhesive or the like. In an embodiment of the invention, the board substrate may be partially removed and the wires may be present independently, which is a so-called flying lead structure. It is also an embodiment of the invention that the surface of the wires is partially or entirely plated with a metal such as gold or tin.

The cured films of the invention may be used as surface protective films for electronic circuit boards, and may be particularly preferably used as surface protective films for flexible printed wiring boards.

The cured films may be present on part or the entire of the surface of electronic circuit boards.

Flexible printed wiring boards are printed circuit boards that can be bent. In detail, such printed wiring boards have substrates composed of resin films such as polyethylene terephthalate resin (PET) substrates, polyimide resin substrates and liquid crystal polymer substrates.

The cured films of the invention may be used as surface protective films for chip-on-film (COF) boards.

The cured films may be present on part or the entire of the surface of chip-on-film (COF) boards.

Chip-on-films (COF) are a type of the flexible printed wiring boards. They have copper wires on resin films such as polyimide resin films, and the surface is coated with an insulating protective film. Chips such as IC and LSI are mounted on the wiring boards.

Accordingly, the chip-on-films do not have an insulating protective film on wire portions on which chips such as IC or LSI are mounted or wire portions through which signals are input in or output from the wiring boards.

In an embodiment of chip-on-films (COF) in which the cured films of the invention provide particularly high advantages, the substrate is composed of a polyimide resin, copper wires are provided on an upper surface of the substrate without an adhesive or the like, the surface of the copper wires is partially or entirely plated with tin, and wire portions on which chips such as IC or LSI are mounted are supported by the polyimide resin substrate (unlike a flying lead structure).

In a preferred embodiment, the electronic circuit boards or the chip-on-film boards in which the surface is partially or entirely covered with the cured film of the invention are incorporated in electronic devices.

For example, the circuit boards may be mounted with driver IC (LSI) for flat panel displays such as liquid crystal displays in liquid crystal display TVs, plasma TVs, liquid crystal monitors and personal computers.

In the chip-on-films (COF), the progress in high-resolution displays has led to an increased number of pins in chips such as IC or LSI and consequently the distance between wires on driver boards has been and will be increasingly reduced. Accordingly, it is more important than ever that minor abnormalities in wire configuration or foreign matters in the insulating protective films should be detected. Currently, the chip-on-films (COF) under mass production have a pitch of 35 to 40 µm (the total of wire width and interwire distance), but the chip-on-films are expected to be designed with a 30 µm pitch or a 25 µm pitch. Accordingly, the detection of abnormalities in fine wires and insulating protective films between or on the wires is a fundamental problem.

The method for inspecting electronic circuit boards according to the invention is a superior technology that satisfies the needs in solving such problems.

In the inspection of electronic circuit boards coated with the cured films of the invention as surface protective films, reflected images and/or transmitted images of the circuit boards projected through a camera under the illumination of light will enable detection of foreign matters, bubbles and aggregated pigments or fillers in the surface protective films, as well as detection of defective circuits on the electronic circuit boards.

The light is preferably a green light and/or a red light in view of the facts that the surface protective films for electronic circuit boards are preferably green and foreign matters such as metals are highly visible under the illumination of red light.

The camera used as an observation apparatus in the inspection is preferably a CCD camera in view of sensitivity.

Thus, an effective observation apparatus is an image processing system including a CCD camera. In particular, AVS-5000 Series (AJUHITEK INC. (Korea)), in detail AVS-5200 and AVS-5500, are suitable.

### EXAMPLES

The present invention will be described in greater detail by examples hereinbelow without limiting the scope of the invention.

### [Printing conditions]

The resin composition was applied on a prescribed substrate by screen printing through a 250 mesh stainless steel screen such that the dry thickness would be 10 µm.

### [Curing conditions]

The composition that was printed under the above printing conditions was dried at room temperature for at least 5 minutes and was thermally cured at 120°C in an air atmosphere for 2 hours.

### [Evaluation method: transmittance]

The resin composition was printed on a 25 µm thick polyethylene film under the printing conditions as described above and was cured under the above curing conditions to give a sample.

The transmittance of the sample was measured with spectrophotometer UV-3100 PC (manufactured by Shimadzu Corporation) equipped with integrating sphere attachment LISR-3100 (150 mm diameter). In the measurement, the background adjustment was made in the wavelength region of 400 nm to 700 nm with the transmittance of the uncoated polyethylene film at 100%.

### [Evaluation method: reflectance]

The resin composition was printed on a 25 µm thick polyethylene film under the printing conditions as described above and was cured under the above curing conditions to give a sample.

The reflectance of the sample was measured with spectrophotometer UV-3100 PC (manufactured by Shimadzu Corporation) equipped with integrating sphere attachment LISR-3100 (150 mm diameter). The reference was a barium sulfate plate that was white according to the Munsell color system. The background adjustment was made in the wavelength region of 400 nm to 700 nm with the reflectance of the white plate at 100%.

### [Evaluation method: gloss value]

The resin composition was printed on a 38 µm thick polyimide film (KAPTON 150EN manufactured by DU PONT-TORAY CO., LTD.) under the printing conditions as described above and was cured under the above curing conditions to give a sample.

To determine the gloss value of the sample, light was applied to the surface coated with the resin composition and the gloss value was measured with a digital variable gloss meter (Suga Test Instruments Co., Ltd.) setting the incident light angle and the light receiver angle both at 60°.

### [Evaluation method: visibility (presence or absence of gloss lines perpendicular to wires)]

The resin composition was printed under the aforesaid printing conditions on a flexible electronic circuit board based on a polyimide film that had a copper wiring with a wire width/interwire distance of 15 µm/25 µm, and the resin composition was cured under the aforesaid curing conditions to give a sample.

In the printing process, the resin composition was printed such that part of the wiring was exposed from the cured film and the edge faces of the printed resin composition were perpendicular to the wires. A transmitted image of the sample under the illumination of oblique light was observed with digital microscope KH-7700 (manufactured by KEYENCE CORPORATION) at x100 magnification such that an edge face of the printed cured film of the resin composition was displayed in the center of the screen.

The visibility (the presence or absence of gloss lines perpendicular to the wires) of the sample was evaluated based on the following criteria.
A: No gloss lines perpendicular to the wires were observed in the vicinity of the edge face of the printed cured film of the resin composition.
B: Gloss lines perpendicular to the wires were observed in the vicinity of the edge face of the printed cured film of the resin composition.

This testing reflected a phenomenon in which a difference in images occurred by differing conditions of illumination or camera.

### [Evaluation method: visibility (under the illumination of green light)]

The resin composition was printed under the aforesaid printing conditions on a flexible electronic circuit board based on a polyimide film that had a copper wiring with a wire width/interwire distance of 15 µm/25 µm, and the resin composition was cured under the aforesaid curing conditions to give a sample.

In the printing process, the resin composition was printed such that part of the wiring was exposed from the cured film and the edge faces of the printed resin composition were perpendicular to the wires. A transmitted image of the sample under the illumination of oblique green light obtained through a green filter was projected with digital microscope KH-7700 (manufactured by KEYENCE CORPORATION) at x100 magnification such that an edge face of the printed cured film of the resin composition was displayed in the center of the screen.

The visibility (under the illumination of green light) of the sample was evaluated based on the following criteria.
A: The surface of the cured film was uniform and clear, and the wires were observed clearly.
B: The surface of the cured film was not clear and the observation of the wires was difficult.

### [Evaluation method: visibility (under the illumination of red light)]

The resin composition was printed under the aforesaid printing conditions on a flexible electronic circuit board based on a polyimide film that had a copper wiring with a wire width/interwire distance of 15 µm/25 µm, and the resin composition was cured under the aforesaid curing conditions to give a sample.

In the printing process, the resin composition was printed such that part of the wiring was exposed from the cured film and the edge faces of the printed resin composition were perpendicular to the wires. A transmitted image of the sample under the illumination of oblique red light obtained through a red filter was projected with digital microscope KH-7700 (manufactured by KEYENCE CORPORATION) at x100 magnification such that an edge face of the printed cured film of the resin composition was displayed in the center of the screen.

The visibility (under the illumination of red light) of the sample was evaluated based on the following criteria.
A: The surface of the cured film was uniform and clear, and the wires were observed clearly.
B: The surface of the cured film was not clear and the observation of the wires was difficult.

### [Evaluation method: visibility (presence or absence of foreign matters, bubbles or aggregates)]

The resin composition was printed on a 25 µm thick polyethylene film under the aforesaid printing conditions and was cured under the aforesaid curing conditions to give a sample.

A transmitted image of the sample at x50 magnification was observed with digital microscope KH-7700 (manufactured by KEYENCE CORPORATION).

The visibility (the presence or absence of foreign matters, bubbles or aggregates) of the sample was evaluated based on the following criteria.
A: The sample contained no foreign matters, bubbles or aggregates.
B: The sample contained foreign matters, bubbles or aggregates.

### <Synthetic Example 1>

### Carboxyl group-containing polyurethane resin (U-1)

A reactor equipped with a stirrer, a thermometer and a condenser was charged with 70.7 g of C-1065N (manufactured by KURARAY CO., LTD., polycarbonate diol, raw material diol molar ratio = 1,9-nonanediol:2-methyl-1,8-octanediol = 65:35, molecular weight: 991) as a polyol compound, 13.5 g of 2,2-dimethylolbutanoic acid (manufactured by Nippon Kasei Chemical Co., Ltd.) as a carboxyl group-containing dihydroxy compound, and 128.9 g of diethylene glycol ethyl ether acetate (manufactured by DAICEL CHEMICAL INDUSTRIES, LTD.) as a solvent. The materials were dissolved by heating at 90°C. The resultant solution was cooled to 70°C. Subsequently, 42.4 g of DESMODULE W (methylene bis(4-cyclohexyl isocyanate)) (manufactured by Sumika Bayer Urethane Co. , Ltd.) as a polyisocyanate was added dropwise to the solution with use of a dropping funnel over a period of 30 minutes. After the completion of the dropwise addition, reaction was performed at 80°C for 1 hour, at 90°C for 1 hour and at 100°C for 2 hours until the isocyanate was consumed. The consumption of the isocyanate was confirmed by obtaining an infrared absorption spectrum of the reaction liquid and confirming the disappearance of an absorption peak near 2300 cm⁻¹ assigned to the isocyanate.

Thereafter, 1.46 g of isobutanol (manufactured by Wako Pure Chemical Industries, Ltd.) was added dropwise to the reaction liquid and reaction was carried out at 105°C for 1.5 hours, thereby obtaining 243 g of a carboxyl group-containing polyurethane resin (U-1).

The carboxyl group-containing polyurethane resin (U-1) had a solid concentration of 50% by mass, a number average molecular weight of 6,800, and an acid value in the solid of 39.9 mg KOH/g.

### (Synthetic Example 2)

### Carboxyl group-containing polyurethane resin (U-2)

A reactor equipped with a stirrer, a thermometer and a condenser was charged with 1172 g of G-1000 (manufactured by NIPPON SODA CO., LTD., polybutadiene having 1,2-repeating units) as a polymer polyol, 184.5 g of dimethylolbutanoic acid (manufactured by Nippon Kasei Chemical Co., Ltd.) as a carboxyl group-containing dihydroxy compound, and 1744 g of diethylene glycol ethyl ether acetate (manufactured by DAICEL CHEMICAL INDUSTRIES, LTD.) as a solvent. The materials were dissolved by heating at 90°C. The resultant solution was cooled to 70°C. Subsequently, 125 g (0.48 mol) of DESMODULE W (manufactured by Sumika Bayer Urethane Co., Ltd.) as a polyisocyanate was added dropwise to the solution with use of a dropping funnel over a period of 30 minutes. After the completion of the dropwise addition, reaction was performed at 80°C for 3 hours, at 90°C for 3 hours and at 100°C for 3 hours until the isocyanate was consumed. The consumption of the isocyanate was confirmed by obtaining an infrared absorption spectrum of the reaction liquid and confirming the disappearance of an absorption peak near 2300 cm⁻¹ assigned to the isocyanate.

Thereafter, 4.4 g (0.06 mol) of isobutanol (manufactured by Wako Pure Chemical Industries, Ltd.) was added dropwise to the reaction liquid and reaction was carried out at 100°C for 1.5 hours, thereby obtaining 3060 g of a carboxyl group-containing polyurethane resin (U-2).

The carboxyl group-containing polyurethane resin (U-2) had a solid concentration of 46% by mass, a number average molecular weight of 7,800, and an acid value in the solid of 35.0 mg KOH/g.

### (Green pigment/resin masterbatch)

In a planetary mixer, 100 g of the carboxyl group-containing polyurethane resin (U-1) from Synthetic Example 1, 25 g of green pigment No. 8800 (manufactured by TOYO INK MFG, CO., LTD.), 0.1 g of AJISPER P822 (manufactured by Ajinomoto Fine-Techno Co., Inc.) as a pigment dispersant, 0.8 g of AEROSIL 380 (manufactured by NIPPON AEROSIL CO., LTD., silica fine particles, average dispersed particle diameter: 0.2 µm), and 15 g of diethylene glycol ethyl ether acetate were mixed together at 40°C for 4 hours to give 136 g of a green pigment/resin masterbatch. The green pigment/resin masterbatch was kneaded five times in a three-roll mill (RIII-1 PM-2 manufactured by Kodaira Seisakusho Co., Ltd.) at 60°C, and 130 g of a green pigment/resin masterbatch having an average dispersed particle diameter of 0.2 µm was obtained.

### (Blue pigment/resin masterbatch)

In a planetary mixer, 100 g of the carboxyl group-containing polyurethane resin (U-1) from Synthetic Example 1, 35 g of blue pigment PV FAST BLUE BG (manufactured by Clariant (Japan) K.K.), 5.0 g of yellow pigment PV FAST YELLOW H3R (manufactured by Clariant (Japan) K.K.), 0.1 g of AJISPER P822 (manufactured by Ajinomoto Fine-Techno Co., Inc.) as a pigment dispersant, 0.8 g of AEROSIL 380 (manufactured by NIPPON AEROSIL CO., LTD., silica fine particles, average dispersed particle diameter: 0.2 µm), and 15 g of diethylene glycol ethyl ether acetate were mixed together at 40°C for 4 hours to give 150 g of a blue pigment/resin masterbatch. The blue pigment/resin masterbatch was kneaded five times in a three-roll mill (RIII-1 PM-2 manufactured by Kodaira Seisakusho Co., Ltd.) at 60°C, and 145 g of a blue pigment/resin masterbatch having an average dispersed particle diameter of 0.4 µm was obtained.

### [Example 1]

There were roughly kneaded 100 g of the carboxyl group-containing polyurethane resin (U-1) from Synthetic Example 1, 1.5 g of the green pigment/resin masterbatch obtained above, 6. 6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 1B2MZ (manufactured by SHIKOKU CHEMICALS CORPORATION) as a heat curing catalyst, 5.0 g of barium sulfate (average dispersed particle diameter: 4 µm) as an inorganic filler, and 10.0 g of AEROSIL R974 (manufactured by NIPPON AEROSIL CO., LTD., silica fine particles, average dispersed particle diameter: 0.2 µm). The roughly kneaded product was kneaded three times in a three-roll mill to give a resin paste in which the inorganic filler was dispersed uniformly. To the paste, 1.3 g of FLOWLEN 300HF (KYOEISHA CHEMICAL Co., LTD.) as an anti-foaming agent was added, and γ-butyrolactone was added for dilution. Thus, 130 g of a resin composition having a viscosity of 45 Pa·s and a nonvolatile content of 48 parts by mass was obtained.

The composition was evaluated for the transmittance, reflectance, gloss value and visibility by the methods described hereinabove. The results are set forth in Table 1.

### [Example 2]

There were roughly kneaded 100 g of the carboxyl group-containing polyurethane resin (U-1) from Synthetic Example 1, 2. 2 g of the green pigment/resin masterbatch obtained above, 6.6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 2MZ (manufactured by SHIKOKU CHEMICALS CORPORATION) as a heat curing catalyst, 25. 0 g of diethylene glycol ethyl ether acetate dispersion that contained 20% of STAPHYLOID AC-3364 (rubbery core-shell polymer, average dispersed particle diameter: 1 µm, manufactured by GANZ CHEMICAL CO., LTD.) as an organic filler, and 2.0 g of AEROSIL R974 (manufactured by NIPPON AEROSIL CO., LTD., silica fine particles, average dispersed particle diameter: 0.2 µm) The roughly kneaded product was kneaded three times in a three-roll mill to give a resin paste in which the organic filler was dispersed uniformly. To the paste, 1.4 g of anti-foaming silicone TSA 750S (manufactured by GE Toshiba Silicones Co., Ltd.) as an anti-foaming agent was added, and γ-butyrolactone was added for dilution. Thus, 139 g of a resin composition having a viscosity of 45 Pa·s and a nonvolatile content of 46 parts by mass was obtained.

The composition was evaluated for the transmittance, reflectance, gloss value and visibility by the methods described hereinabove. The results are set forth in Table 1.

### [Example 3]

There were roughly kneaded 100 g of the carboxyl group-containing polyurethane resin (U-1) from Synthetic Example 1, 3. 5 g of the green pigment/resin masterbatch obtained above, 6. 6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 1B2MZ (manufactured by SHIKOKU CHEMICALS CORPORATION) as a heat curing catalyst, 7.5 g of X-52-854 (silicone resin powder, average dispersed particle diameter: 0.8 µm, manufactured by Shin-Etsu Chemical Co., Ltd.) as an organic filler, and 5.0 g of AEROSIL R974 (manufactured by NIPPON AEROSIL CO., LTD., silica fine particles, average dispersed particle diameter: 0.2 µm). The roughly kneaded product was kneaded three times in a three-roll mill to give a resin paste in which the organic filler was dispersed uniformly. To the paste, 1.3 g of FLOWLEN 300HF (KYOEISHA CHEMICAL Co. , LTD.) as an anti-foaming agent was added, and γ-butyrolactone was added for dilution. Thus, 131 g of a resin composition having a viscosity of 46 Pa·s and a nonvolatile content of 48 parts by mass was obtained.

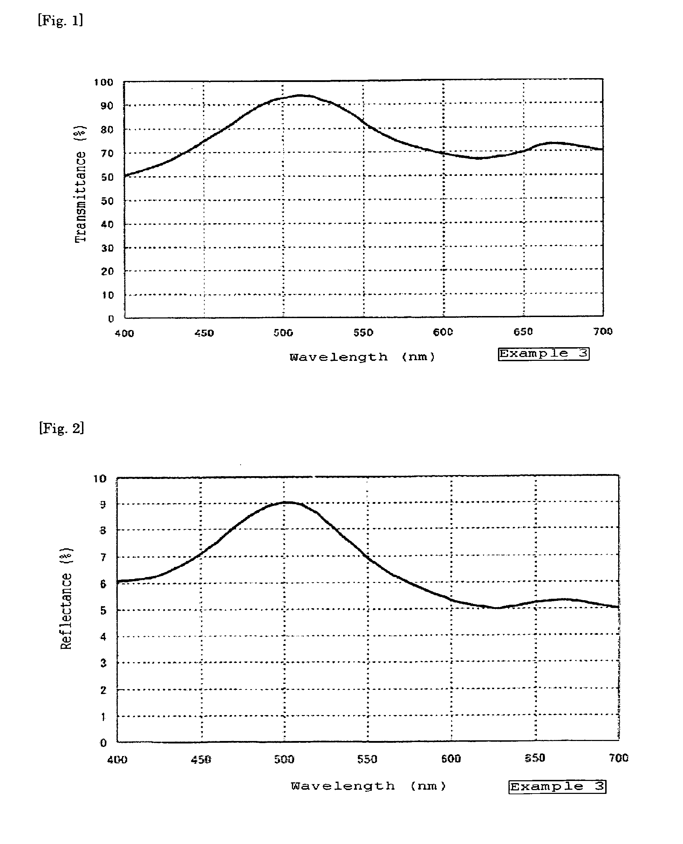

The composition was evaluated for the transmittance, reflectance, gloss value and visibility by the methods described hereinabove. The results are set forth in Table 1. Patterns of transmittance and reflectance are shown in Figs. 1 and 2, respectively.

### [Example 4]

There were roughly kneaded 100 g of the carboxyl group-containing polyurethane resin (U-1) from Synthetic Example 1, 2. 2 g of the green pigment/resin masterbatch obtained above, 6. 6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 2MZ (manufactured by SHIKOKU CHEMICALS CORPORATION) as a heat curing catalyst, 50.0 g of diethylene glycol ethyl ether acetate dispersion that contained 20% of VYLON GK-390 (polyester urethane resin, acid value: 30 mg KOH/g, manufactured by TOYOBO CO., LTD.) as a resin for forming domains, and 4.0 g of AEROSIL R974 (manufactured by NIPPON AEROSIL CO., LTD., silica fine particles, average dispersed particle diameter: 0.2 µm). The roughly kneaded product was kneaded three times in a three-roll mill to give a resin paste in which AEROSIL R974 was dispersed uniformly, VYLON GK-390 formed domains having an average dispersed particle diameter of 10 µm, and no bubbles were caused in the interface between VYLON GK-390 and the carboxyl group-containing polyurethane resin (U-1).

To the paste, 1.4 g of anti-foaming silicone TSA 750S (manufactured by GE Toshiba Silicones Co., Ltd.) as an anti-foaming agent was added, and γ-butyrolactone was added for dilution. Thus, 151 g of a resin composition having a viscosity of 45 Pa·s and a nonvolatile content of 46 parts by mass was obtained.

The composition was evaluated for the transmittance, reflectance, gloss value and visibility by the methods described hereinabove. The results are set forth in Table 1.

### [Example 5]

There were roughly kneaded 100 g of the carboxyl group-containing polyurethane resin (U-1) from Synthetic Example 1, 3.5 g of the blue pigment/resin masterbatch obtained above, 6. 6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 2MZ (manufactured by SHIKOKU CHEMICALS CORPORATION) as a heat curing catalyst, 7.5 g of X-52-854 (silicone resin powder, average dispersed particle diameter: 0.8 µm, manufactured by Shin-Etsu Chemical Co., Ltd.) as an organic filler, and 5.0 g of AEROSIL R974 (manufactured by NIPPON AEROSIL CO., LTD., silica fine particles, average dispersed particle diameter: 0.2 µm). The roughly kneaded product was kneaded three times in a three-roll mill to give a resin paste in which the organic filler was dispersed uniformly. To the paste, 1.3 g of FLOWLEN 300HF (KYOEISHA CHEMICAL Co. , LTD.) as an anti-foaming agent was added, and γ-butyrolactone was added for dilution. Thus, 125 g of a resin composition having a viscosity of 46 Pa·s and a nonvolatile content of 48 parts by mass was obtained.

The composition was evaluated for the transmittance, reflectance, gloss value and visibility by the methods described hereinabove. The results are set forth in Table 1.

### [Comparative Example 1]

A resin composition weighing 129 g was obtained in the same manner as in Example 1, except that 1.5 g of the green pigment/resin masterbatch was replaced by 0.26 g of green pigment No. 8800. The average dispersed particle diameter of the green pigment was 3 µm, and pigment aggregates had a maximum diameter of 5 µm.

The composition was evaluated for the transmittance, reflectance, gloss value and visibility by the methods described hereinabove. The results are set forth in Table 1.

### [Comparative Example 2]

A resin composition weighing 130 g was obtained in the same manner as in Example 3, except that 7.5 g of the organic filler X-52-854 (silicone resin powder, average dispersed particle diameter: 0.8 µm, manufactured by Shin-Etsu Chemical Co., Ltd.) was replaced by TECHPOLYMER MBX-15 having a specific gravity of 1.2 and an average dispersed particle diameter of 15 µm (manufactured by SEKISUI PLASTICS CO., LTD.).

The composition was evaluated for the transmittance, reflectance, gloss value and visibility by the methods described hereinabove. The results are set forth in Table 1.

### [Comparative Example 3]

There were kneaded 70 g of the carboxyl group-containing polyurethane resin (U-1) from Synthetic Example 1, 1.5 g of the green pigment/resin masterbatch obtained above, 6.6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 2MZ (manufactured by SHIKOKU CHEMICALS CORPORATION) as a heat curing catalyst, 5.0 g of barium sulfate (average dispersed particle diameter: 4 µm) as an inorganic filler, and 10.0 g of AEROSIL R974 (manufactured by NIPPON AEROSIL CO., LTD., silica fine particles, average dispersed particle diameter: 0.2 µm) in a planetary mixer for 1 hour. Subsequently, 30 g of the carboxyl group-containing polyurethane resin (U-2) from Synthetic Example 2 was added, and the mixture was kneaded in a planetary mixer for 1 hour. The kneaded product was further kneaded three times in a three-roll mill to give a resin paste. To the paste, 1.3 g of anti-foaming silicone TSA 750S (manufactured by GE Toshiba Silicones Co., Ltd.) as an anti-foaming agent was added, and γ-butyrolactone was added for dilution. Thus, 121 g of a resin composition was obtained in which the viscosity was 45 Pa·s, the nonvolatile content was 48 parts by mass, and the carboxyl group-containing polyurethane resin (U-2) formed domains with an average dispersed particle diameter of 30 µm.

The composition was evaluated for the transmittance, reflectance, gloss value and visibility by the methods described hereinabove. The results are set forth in Table 1.

### [Comparative Example 4]

There were roughly kneaded 100 g of the carboxyl group-containing polyurethane resin (U-1) from Synthetic Example 1, 0. 5 g of the green pigment/resin masterbatch obtained above, 6. 6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 1B2MZ (manufactured by SHIKOKU CHEMICALS CORPORATION) as a heat curing catalyst, 10.0 g of barium sulfate (average dispersed particle diameter: 4 µm) as an inorganic filler, and 5.0 g of AEROSIL R974 (manufactured by NIPPON AEROSIL CO., LTD., silica fine particles, average dispersed particle diameter: 0.2 µm). The roughly kneaded product was kneaded three times in a three-roll mill to give a resin paste. To the paste, 1. 3 g of FLOWLEN 300HF (KYOEISHA CHEMICAL Co., LTD.) as an anti-foaming agent was added, and γ-butyrolactone was added for dilution. Thus, 124 g of a resin composition was obtained in which the viscosity was 45 Pa·s, the nonvolatile content was 48 parts by mass, and the pigment concentration was less than 0.2% of the resin composition.

The composition was evaluated for the transmittance, reflectance, gloss value and visibility by the methods described hereinabove. The results are set forth in Table 1.

### [Comparative Example 5]

There were roughly kneaded 100 g of the carboxyl group-containing polyurethane resin (U-1) from Synthetic Example 1, 4.5 g of the green pigment/resin masterbatch obtained above, 6. 6 g of jER 828EL (bisphenol A bifunctional epoxy resin, manufactured by Japan Epoxy Resins Co., Ltd.) (the amount corresponding to 1 equivalent weight of the epoxy groups relative to the carboxyl groups), 0.5 g of 1B2MZ (manufactured by SHIKOKU CHEMICALS CORPORATION) as a heat curing catalyst, 20.0 g of barium sulfate (average dispersed particle diameter: 4 µm) as an inorganic filler, and 5.0 g of AEROSIL R974 (manufactured by NIPPON AEROSIL CO., LTD., silica fine particles, average dispersed particle diameter: 0.2 µm). The roughly kneaded product was kneaded three times in a three-roll mill to give a resin paste. To the paste, 1. 3 g of FLOWLEN 300HF (KYOEISHA CHEMICAL Co., LTD.) as an anti-foaming agent was added, and γ-butyrolactone was added for dilution. Thus, 132 g of a resin composition having a viscosity of 45 Pa·s and a nonvolatile content of 48 parts by mass was obtained. The composition had a low transmittance.

The composition was evaluated for the transmittance, reflectance, gloss value and visibility by the methods described hereinabove. The results are set forth in Table 1.

**[Table 1]**

| | Transmittance | | Reflectance | | Gloss value | Visibility | | | |
|---|---|---|---|---|---|---|---|---|---|
| | Maximum | Minimum | Maximum | Minimum | | Gloss lines | Under green light | Under red light | Foreign matters, bubbles or aggregates |
| Ex. 1 | 99 | 70 | 6.3 | 3.7 | 91 | A | A | A | A |
| Ex. 2 | 99 | 75 | 10.0 | 6.0 | 80 | A | A | A | A |
| Ex. 3 | 94 | 67 | 9.0 | 5.0 | 85 | A | A | A | A |
| Ex. 4 | 99 | 69 | 6.8 | 3.9 | 82 | A | A | A | A |
| Ex. 5 | 91 | 60 | 8.9 | 5.0 | 81 | A | A | A | A |
| Comp. Ex. 1 | 99 | 85 | 6.0 | 3.6 | 87 | A | B | B | B |
| Comp. Ex. 2 | 92 | 63 | 12.0 | 7.0 | 35 | A | B | B | B |
| Comp. Ex. 3 | 99 | 73 | 7.1 | 4.0 | 54 | B | A | A | B |
| Comp. Ex. 4 | 100 | 93 | 12.0 | 7.0 | 100 | B | A | B | A |
| Comp. Ex. 5 | 89 | 56 | 5.1 | 2.0 | 84 | A | B | A | A |

| | | | | | | | | | |
|---|---|---|---|---|---|---|---|---|---|
| In Table 1, the measurements used light having a wavelength as follows. Transmittance (maximum) and reflectance (maximum) ··· wavelengths from 500 nm to 550 nm Transmittance (minimum) and reflectance (minimum) ··· wavelengths from 600 nm to 650 nm | | | | | | | | | |

### [INDUSTRIAL APPLICABILITY]

When the resin compositions of the invention are used as surface protective films for electronic circuit boards, the surface protective films allow for accurate automated inspection of the electronic circuit boards coated therewith, and foreign matters, bubbles and aggregated pigments or fillers in the surface protective films and defective circuits can be detected accurately irrespective of the light intensity or the angle or sensitivity of a CCD camera. Therefore, the resin compositions of the invention can be used in solder resist inks, overcoating inks, electric insulating materials such as interlayer dielectric films, IC- or ULSI-encapsulating materials, and laminates.

## Claims

1. A resin composition which comprises a color pigment (A) and a curable resin (B) and wherein a film (dry thickness: 10 µm ± 1 µm) comprising a cured product of the resin composition satisfies the following requirements (I), (II), (III), (IV) and (V):
(I) the maximum transmittance of light having wavelengths of 500 nm to 550 nm is not less than 90%;
(II) the minimum transmittance of light having wavelengths of 600 nm to 650 nm is less than 80%;
(III) the maximum reflectance of light having wavelengths of 500 nm to 550 nm is less than 12%;
(IV) the minimum reflectance of light having wavelengths of 600 nm to 650 nm is less than 7%;
(V) the 60° gloss value measured with white light is not less than 80.

2. The resin composition according to claim 1, wherein the composition contains the color pigment (A) at 0.2 to 5 parts by mass based on 100 parts by mass of the total of the color pigment (A) and the curable resin (B).

3. The resin composition according to claim 1 or 2, wherein the average diameter of dispersed particles of the color pigment (A) is not more than 1 µm.

4. The resin composition according to any one of claims 1 to 3, wherein the color pigment (A) is at least one pigment and shows a green color.

5. The resin composition according to any one of claims 1 to 4, wherein the curable resin (B) is a heat-curable resin or a UV-curable resin.

6. The resin composition according to any one of claims 1 to 5, wherein the composition further comprises an inorganic filler or an organic filler and the average diameter of dispersed particles of the inorganic filler or the organic filler is not more than 10 µm.

7. A cured film obtained by curing the resin composition described in any one of claims 1 to 6.

8. The cured film according to claim 7, wherein the cured film has a matrix/domain structure and the average diameter of the dispersed domains in the matrix/domain structure is not more than 10 µm.

9. A cured resin film satisfying the following requirements (I), (II), (III), (IV) and (V):
(I) the maximum transmittance of light having wavelengths of 500 nm to 550 nm is not less than 90%;
(II) the minimum transmittance of light having wavelengths of 600 nm to 650 nm is less than 80%;
(III) the maximum reflectance of light having wavelengths of 500 nm to 550 nm is less than 12%;
(IV) the minimum reflectance of light having wavelengths of 600 nm to 650 nm is less than 7%;
(V) the 60° gloss value measured with white light is not less than 80.

10. An overcoat for electronic circuit boards comprising the cured film described in any one of claims 7 to 9.

11. An electronic circuit board which has a surface partially or entirely coated with the cured film described in any one of claims 7 to 9.

12. An electronic device comprising the electronic circuit board described in claim 11.

13. A method for inspecting electronic circuit boards, which comprises inspecting an electronic circuit board having a surface partially or entirely coated with the cured film described in any one of claims 7 to 9, via a reflected image and/or a transmitted image of the board projected through a camera under the illumination of light.

14. The method for inspecting electronic circuit boards according to claim 13, wherein the illumination of light is illumination of green light and/or illumination of red light.

15. The method for inspecting electronic circuit boards according to claim 13 or 14, wherein the camera is a CCD camera.
